# EUROPEAN PATENT SPECIFICATION

(11) **EP 1 535 326 B1**
(45) Date of publication and mention of the grant of the patent: **09.09.2009**
(21) Application number: 03762848.4
(22) Date of filing: 09.07.2003
(51) Int. Cl.: H01L 21/762

(54) **TRANSFER OF A THIN LAYER FROM A WAFER COMPRISING A BUFFER LAYER**
TRANSFER EINER DÜNNSCHICHT VON EINEM WAFER MIT EINER PUFFERSCHICHT
TRANSFERT D'UNE COUCHE MINCE D'UNE TRANCHE SEMI-CONDUCTRICE COMPORTANT UNE COUCHE TAMPON

(30) Priority: 09.07.2002 FR 0208600
(43) Date of publication of application: 01.06.2005
(73) Proprietor: S.O.I. Tec Silicon on Insulator Technologies, 38190 Bernin (FR)
(72) Inventor: GHYSELEN, Bruno, F-38170 Seyssinet-Pariset (FR); AULNETTE, Cécile, F-38000 Grenoble (FR); OSTERNAUD, Bénédite, 38380 Saint Laurent Du Pont (FR); DAVAL, Nicolas, F-38000 Grenoble (FR)
(74) Representative: Texier, Christian
(86) International application number: PCT/IB2003/003466
(87) International publication number: WO 2004/006327

(56) References cited:
- WO-A-01/11930
- WO-A-02/15244
- WO-A-99/52145
- GB-A- 2 365 214
- US-A- 6 059 895
- US-A1- 2002 081 861
- US-B1- 6 323 108
- US-B1- 6 410 371
- HUANG L J ET AL: "SIGE-ON-INSULATOR PREPARED BY WAFER BONDING AND LAYER TRANSFER FOR HIGH-PERFORMANCE FIELD-EFFECT TRANSISTOR" APPLIED PHYSICS LETTERS, AMERICAN INSTITUTE OF PHYSICS. NEW YORK, US, vol. 78, no. 9, 26 February 2001 (2001-02-26), pages 1267-1269, XP001020601 ISSN: 0003-6951

## Description

The present invention relates to a transfer of thin layers from a wafer to a receiving substrate, in order to form structures such as a semiconductor-on-insulator structures, also called a SeOI (Semiconductor-on-insulator) structures.

A first object of a such transfer is usually to produce electronic structures whose active layer, that is to say the layer which comprises or which will comprise the electronic components, is particularly thin and particularly homogeneous through the thickness.

A second object of the transfer can also be to produce these structures by transferring the active layer onto a receiving substrate from a wafer comprising a buffer layer.

A third object of the transfer may be to provide the possibility of reusing part of the wafer, and especially at least part of the buffer layer, for another transfer.

The term "buffer layer" is understood to mean a layer intermediate between two crystallographic structures with different lattice parameters, having in the region of one of its faces a lattice parameter substantially identical to that of the first structure and in the region of its other face a lattice parameter substantially identical to that of the second structure.

Thus, a wafer may, for example, comprise a single-crystal silicon (also called Si) wafer on which a relaxed layer of silicon-germanium (also called SiGe) is produced by means of a buffer layer, despite the difference in lattice parameter existing between these two materials.

By "relaxed layer" it is meant a layer of a semiconductor material, having a crystallographic relaxation rate, as measured by X-ray diffraction or Raman spectroscopy, superior to 50%. A layer having a 100% relaxation rate, has a lattice parameter substantially identical to the nominal lattice parameter of the material of the layer, that is to say the lattice parameter of the material in its bulk form in equilibrium.

Conversely, the term "strained layer" means any layer of a semiconductor material whose crystallographic structure is strained in tension or in compression during crystal growth, such as epitaxy, requiring at least one lattice parameter to be substantially different from the nominal lattice parameter of this material.

Thus, a buffer layer makes it possible to grow a SiGe layer on a Si substrate without this SiGe layer being strained by the Si substrate.

Given that bulk SiGe is usually not available on the market, the use of a buffer layer in a wafer in order to have a relaxed SiGe layer on the surface makes it possible to produce a structure which can thus fulfil the same functions as a bulk SiGe substrate.

The buffer layer inserted between the Si wafer and the relaxed SiGe layer is generally made of SiGe, with a quantitywise proportion of germanium which progressively increases through the thickness of the wafer towards the relaxed layer.

Thus a silicon-germanium buffer layer can be referred as a Si₁₋ₓGeₓ buffer layer, the x parameter representing the germanium concentration in the buffer layer increasing progressively from 0 to r.

The relaxed SiGe layer on the surface of the Si₁₋ₓGeₓ buffer layer is thus referred as the relaxed Si₁₋ᵣGeᵣ layer, the r parameter representing the germanium concentration in said relaxed layer.

Thus, the Si₁₋ₓGeₓ buffer layer makes it possible to:
- gradually increase the germanium content x from the wafer (x=0) towards the relaxed layer (x=r);
- confine defects associated with the difference in lattice parameter so that they are buried;
- give a sufficiently thick relaxed Sh₁₋ᵣGeᵣ layer stability with respect to a film of different material epitaxially grown on its surface in order to strain the latter so as to modify its lattice parameter without influencing that of the relaxed Si₁₋ᵣGeᵣ layer.

For all these reasons, the buffer layer must be sufficiently thick, typically having a value greater than one micron.

It has also to be stated that controlling the germanium concentration within a relaxed SiGe layer makes it possible to control its lattice parameter and thus the strain exerted on a film epitaxially grown on said relaxed SiGe layer.

Another object of the invention aims at controlling the different structural states (strain or relaxation rates) of the various layers composing the final structure (such as a relaxed SiGe layer) and more particularly at exceeding the restrictions of the current techniques limiting to approximately 30% the concentration r of germanium within the relaxed Si₁₋ᵣ Geᵣ layer on the surface of the Si₁₋ₓGeₓ buffer layer.

Processes of transferring the layer of relaxed material grown epitaxially on such a buffer layer from the wafer on to a receiving substrate are known.

Such processes are, for example, proposed in an IBM document by L.J. Huang et al. ("SiGe-On-Insulator prepared by wafer bonding and layer transfer for high-performance field-effect transistors", Applied Physics Letters, 26/02/2001, Vol. 78, No. 9) and in document WO 02/33746, in which documents an SGOI (Silicon-Germanium-On-Insulator) structure is produced from a wafer comprising in succession a single-crystal Si support substrate, an SiGe buffer layer and a relaxed SiGe layer.

One process employed in a document by L.J. Huang et al. consists in carrying out a Smart-Cut® process of the Applicant, known to those skilled in the art, and descriptions of which may be found in a number of works dealing with wafer reduction techniques, in order to remove the relaxed SiGe layer so as to transfer it by means of bonding on to an oxidized receiving substrate, thus producing an SGOI structure.

Despite the advantages that this process affords, a few rough areas may form on the surface of the transferred layer and a surface finishing step then has to be carried out.

This finishing step is generally carried out by means of CMP (chemical-mechanical polishing or chemical-mechanical planarization), which may create surface defects (such as strain-hardened regions), which may imperfectly correct the thickness, and thus retain inhomogeneous layer thicknesses, and which may slow down the transfer of the SiGe layer, and increase its cost.

The process presented in document WO 02/33746 includes, in addition to a CMP polishing step, preliminary lapping, polishing and etching steps in order to remove part of the wafer, thereby slowing down the overall process of removal from the wafer and increasing its cost even further, while not ensuring good homogeneity in layer thickness.

The abovementioned first object of the transfer is therefore not sufficiently achieved in this case.

To try to alleviate this, document US 5 882 987 and US 6 323 108 disclose an overall process for producing SOI (silicon-on-insulator) structures from a wafer comprising in succession a single-crystal Si support substrate, an SiGe layer and an epitaxially grown Si layer bonded to an oxidized receiving substrate.

The Smart-Cut® technique is employed and causes, after bonding the wafer to a receiving substrate, detachment of part of the wafer at the Si support substrate.

A structure consisting in succession of part of the Si support substrate, the SiGe layer and the epitaxially grown Si layer is thus removed, the whole assembly being bonded to the oxidized receiving substrate.

Two successive selective etching operations are then carried out on the structure in order to remove firstly the remaining part of the Si support substrate with an etching solution such that the SiGe layer forms a stop layer and then in order to remove the SiGe layer with an etching solution such that the Si layer forms a stop layer.

The structure obtained at the end is an SOI structure with a surface Si layer.

Thus, an SeOI structure is obtained with a semiconductor layer which is both thin and uniform through the thickness, substantially identical to the epitaxially grown initial layer, while avoiding the use of a finishing step other than a selective etching operation.

However, the SiGe layer inserted between the Si wafer and the epitaxially grown Si layer has a typical thickness of between 0.01 and 0.2 microns, a thickness which is insufficient, as mentioned above, to pretend to fulfil the rote of a buffer layer between the Si wafer and a potential relaxed SiGe layer.

The wafer therefore does not include a buffer layer.

The abovementioned second object of the transfer is therefore not achieved in this case.

In addition, given the order of magnitude of the thickness of the inserted SiGe layer, the structural state of the latter does not seem defined with certainty.

Now, another main objective of the transfer relates also to the production of a final structure comprising one or more layers in substantially controlled structural states, such as a substantially relaxed SiGe layer, something which does not seem to be guaranteed in the production of a structure described in the document US 6 323 108.

As regards document WO 01/99169, this provides processes for producing, from a wafer consisting in succession of an Si substrate, an SiGe buffer layer, a relaxed SiGe layer and optionally a strained Si or SiGe layer, a final structure with the relaxed SiGe layer on the optional other strained Si or SiGe layer.

The technique employed for producing such a structure involves, after bonding the wafer to a receiving substrate, removal of the material of the wafer that it is desired not to retain, by selectively etching the Si substrate and the SiGe buffer layer.

Although it transpires that this technique does make it possible to achieve particularly small layer thicknesses which are homogeneous through the thickness, it entails, however, destruction of the Si substrate and the SiGe buffer layer by chemical etching.

These processes therefore do not allow the possibility of reusing part of the wafer, and especially at least part of the buffer layer, for a further transfer of layers.

The third object of the transfer mentioned at the start of the document is therefore not achieved in this case.

WO 02/15244 document describes a source wafer, provided before transfer, comprising relaxed SiGe layer/strained Si/SiGe layer / buffer SiGe layer / Si substrate structure.

Then, the transfer consists doing a Smart-Cut® process at the strained Si layer level.

Implanting ions in the strained layer of Si can be difficult to operate due to the thickness of a such layer, and can thus lead to creation of structural damages inside the SiGe layers surrounding it.

In order in particular to achieve these objectives, the present invention provides, according to a first aspect, a method of producing a structure comprising a thin layer of semiconductor material obtained from a wafer, the wafer comprising a lattice parameter matching layer comprising an upper layer of a material chosen from semiconductor materials having a first lattice parameter, the method comprising the following steps:
(a) growth on the upper layer of the matching layer of a film of a material chosen from semiconductor materials, said grown film being of a material having a nominal lattice parameter substantially different from the first lattice parameter, said grown film having a thickness small enough to keep the first lattice parameter of the upper layer of the underlyed matching layer and thus to be strained;
(b) growth on the film of a relaxed layer, said relaxed layer being of a material chosen from semiconductor materials comprising silicon and at least another element and having a nominal lattice parameter substantially identical to the first lattice parameter;
(c) removal of a part of the wafer, **characterized by** the following operations:
   - formation of an embrittlement zone in the matching layer; and
   - supply of energy in order to detach, at the embrittlement zone level, the part of the wafer comprising the relaxed layer, thus forming the structure to produce;
(d) enrichment in an element other than silicon of the relaxed layer comprised in the detached part of the wafer.

Further characteristics of the method according to the invention are the following :
- the enrichment step comprises an oxidation operation of the detached part of the wafer for forming an oxide layer on the surface of the thus oxidized detached part of the wafer and increasing the concentration of the element other than silicon in a region of said relaxed layer which is subjacent said oxide layer,
- the enrichment step may also comprises a deoxidation operation for removing the oxide layer formed during said oxidation operation.
- the enrichment step may also comprises a heat treatment operation for homogenising the concentration of the element other than silicon within said oxidized part of the wafer;
- the heat treatment operation can be carried out after the oxidation operation, either before or after said deoxydation operation;
- the heat treatment operation is preferentially carried out at a temperature of approximately 1200°C;
- after the growth step (b), an additional step is carried out in which a receiving substrate is bonded to the wafer on the relaxed layer side;
- in this case, the receiving substrate is made of silicon;
- in either of these latter two cases, before bonding, a step of forming at least one bonding layer between the receiving substrate and the wafer is furthermore carried out, the bonding layer being formed on the receiving substrate and/or on the bonding face of the wafer;
- in the latter case, the bonding layer is an electrically insulating material such as silica;
- the embrittlement zone is formed by implantation of species into the matching layer at a depth substantially equal to the implant depth;
- before the growth step (b), the embrittlement zone is formed by porosification of a layer beneath the relaxed layer;
- the removal step (c) comprises, after the energy supply operation of said removal step (c), at least one selective etching operation;
- in one of the latter two cases, a selective etching operation relates to the etching of the remaining part of the matching layer with respect to the film (after detachment of the wafer by energy supply) ;
- it further comprises after said etching operation and before the enrichment step (d) a growth on the film (3) of a film of a semiconductor material substantially the same as the one of the film (3) ;
- it further comprises an oxidation of said grown film ;
- an annealing treatment is operated at the same time or following the oxidation, this annealing treatment being able to strengthen the bonding interface.
- in the latter case, a selective etching operation relates to the etching of the film with respect to the relaxed layer;
- the process furthermore comprises, after the removal step (c), a step of growing a layer on the relaxed layer;
- in this case, the growth layer on the relaxed layer is made of strained material;
- the matching layer is made of silicon-germanium (the matching layer comprising a buffer layer with a germanium concentration which increases through the thickness and a relaxed layer beneath the film), the film of strained material is made of silicon, the element other than silicon is germanium so that the relaxed layer is made of substantially relaxed silicon-germanium (with a germanium concentration substantially equal to the germanium concentration of the relaxed layer of the matching layer);
- the element other than silicon in the relaxed layer may also be carbon or an alloy germanium-carbon;
- in the latter cases, the growth layer produced on the relaxed layer is made of strained silicon so as to substantially preserve the lattice parameter of the subjacent relaxed silicon-germanium layer;
- the wafer comprises at least one layer furthermore containing carbon with a carbon concentration in the layer substantially less than or equal to 50% ;
- the wafer comprises at least one layer furthermore containing carbon with a carbon concentration in the layer substantially less than or equal to 5%.

According to a second aspect, the invention provides a structure, obtained as indicated by the method proposed by the first aspect of the invention after a bounding step with a receiving substrate and said enrichment step (d), comprising in succession at least a receiving substrate and the relaxed layer comprised in the detached part of the wafer and enriched in its element other than silicon, **characterized in that** said relaxed layer has a lattice parameter substantially superior to said first lattice parameter;

According to a third aspect, the invention provides an application of the method proposed by the first aspect of the invention to the production of one of the following "semiconductor on insulator" structures : SGOI, strained Si / SGOI, SiGe / strained Si / SGOI, SiO₂ / SGOI.

Further aspects, objects and advantages of the present invention will become more clearly apparent on reading the following detailed description of the implementation of preferred processes of the invention, these being given by way of non-limiting example and with reference to the appended drawings in which:
- figures 1a, 1b, 1c, 1d, 1e and 1f show the various steps of a method of producing an electronic structure comprising a thin SiGe layer according to the invention;
- figures 2a, 2b, 2c and 2d show the various steps of a treatment applied to a layer made of a semiconductor material comprising silicon and at least another element in order to enrich said layer in said other element.

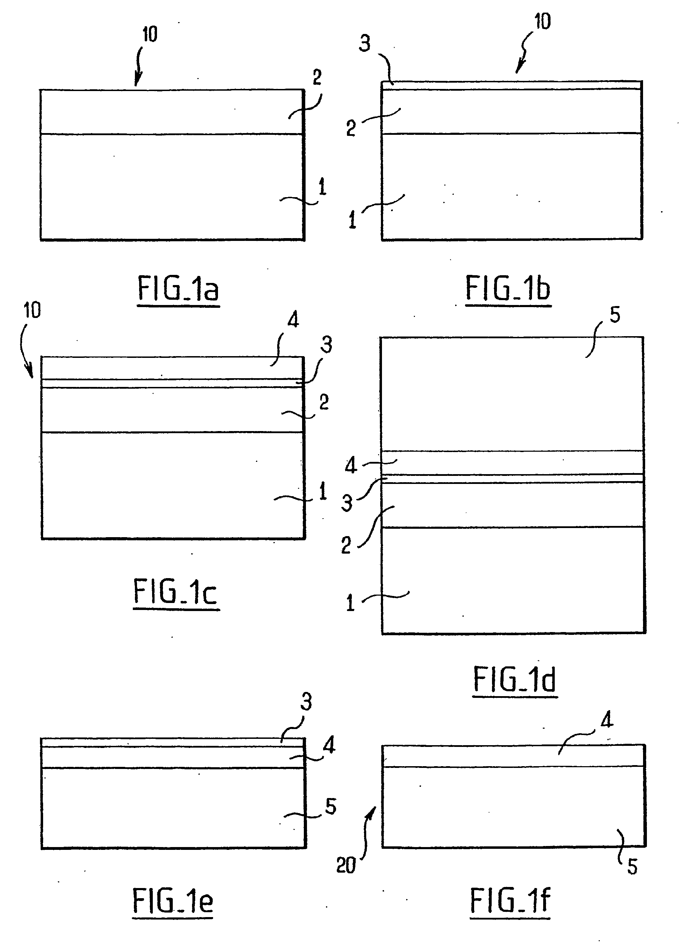

An example of a method according to the invention will now be described below, which starts, with reference to figure 1a, from a wafer 10 consisting in the first place of a single-crystal silicon support substrate 1 and a lattice parameter matching layer 2 made of a semiconductor material comprising silicon and at least another element.

The expression "lattice parameter matching layer" denotes any structure behaving as a buffer layer and having, on the surface, a layer of substantially relaxed material without an appreciable number of structural defects, such as dislocations.

Thus, in our example, it will be advantageous to choose a lattice parameter matching layer 2 made of a semiconductor material comprising silicon and germanium.

Said SiGe lattice parameter matching layer 2 consists in succession of a Si₁₋ₓGeₓ buffer layer, the concentration x of germanium within this buffer layer increasing progressively from 0 to r, and a relaxed Si₁₋ᵣGeᵣ layer on the surface of said Si₁₋ₓGeₓ buffer layer.

The buffer layer preferably has a germanium concentration x which grows uniformly from the interface with the support substrate 1, for reasons which were explained above. Its thickness is typically between 1 and 3 micrometers in order to obtain good structural relaxation on the surface.

The relaxed Sh₁₋ᵣGeᵣ layer has advantageously been formed by epitaxy on the surface of the buffer layer and its thickness may vary widely depending on the case, with a typical thickness of between 0.5 and 1 micron.

The germanium present in the silicon at a concentration r within the relaxed Si₁₋ᵣGeᵣ layer makes it possible to strain a Si film 3, grown on said relaxed Sh₁₋ᵣGeᵣ layer during the next step (shown by Figure 1b).

However, the cost of a buffer layer is generally very important, and its quality is badly controlled once the maximum concentration of germanium within a Si₁₋ₓGeₓ buffer layer becomes high.

Indeed current techniques limit to approximately 30% the concentration r of germanium within the relaxed Si₁₋ᵣGeᵣ layer on the surface of the SiGe lattice parameter matching layer 2. Hence, the constraint exerted on the Si film 3 grown on said matching layer 2 is also limited.

With reference to Figure 1b, an Si film 3 is grown on the SiGe matching layer 2.

In a first case, the film 3 is grown *in situ*, directly in continuation with the formation of the subjacent matching layer 2, the latter also being in this case advantageously formed by layer growth.

In the second case, the film 3 is grown after a gentle finishing step carried out on the surface of the subjacent matching layer 2, for example by CMP polishing.

The Si film 3 is advantageously formed by epitaxy using techniques such as CVD (chemical vapour deposition) and MBE (molecular beam epitaxy) techniques.

The silicon of the film 3 is then obliged by the matching layer 2 to increase its nominal lattice parameter in order to make it substantially identical to that of its growth substrate and thus introduce internal tensile strains.

It is necessary to form quite a thin Si film 3 - this is because too great a film thickness would cause the strain in the thickness of the film to relax towards the nominal lattice parameter of the silicon and/or defects to be generated in the film 3.

The thickness of the film 3 is thus typically less than 200 angstroms in order to avoid any relaxation of the strain therein.

Referring to Figure 1c, a relaxed SiGe layer 4 is grown on the strained Si film 3, advantageously by epitaxy (for example by CVD or MBE).

This relaxed SiGe layer is produced either *in situ*, immediately after growth of the subjacent film 3, or after a soft finishing step carried out on the surface of the subjacent film 3, such as a CMP polishing step.

The germanium concentration in this layer 4 is substantially the same as that present near the bonding face of the matching layer 2 (that is to say a concentration r in Ge), so as to keep the nominal matching parameter of the relaxed Si₁₋ᵣGeᵣ layer present at this level in the matching layer 2 and preserved in the strained Si film 3.

The thickness of this relaxed SiGe layer 4 may be from a few tens to a few hundreds of nanometres, preferably between 10 and 100 nanometres.

With reference to Figure 1d, a receiving substrate 5 is advantageously bonded to the relaxed SiGe layer 4.

This receiving substrate 5 may, for example, be made of silicon or may consist of other types of materials.

The receiving substrate 5 is bonded by bringing it into intimate contact with the relaxed layer 4, advantageously effecting molecular adhesion (wafer bonding) between the substrate 5 and the layer 4.

This bonding technique, as well as variants, is especially described in the document entitled "Semiconductor Wafer Bonding " (Science and Technology, Interscience Technology) by Q.Y. Tong, U. Gösele and Wiley.

If necessary, bonding is accompanied by an appropriate prior treatment of the respective surfaces to be bonded and/or by supplying thermal energy and/or supplying an additional bonding layer.

Thus, for example, a heat treatment carried out during bonding allows the bonds to be strengthened.

Bonding may also be reinforced by a bonding layer inserted between the layer 4 and the receiving substrate 5, which makes it possible to produce molecular bonds both with the layer 4 and with the material constituting the bonding face of the receiving substrate 5 which are at least as strong as those existing between the layer 4 and the receiving substrate 5.

Thus, silicon oxide (also called silica or SiO₂) is a material that may be chosen for producing such a bonding layer. The silica may be formed on the relaxed layer 4 and/or on the receiving substrate 5, by SiO₂ deposition or by thermal oxidation on the respective bonding surfaces.

Advantageously, the material constituting the bonding face of the receiving substrate 5 and/or the material of the bonding layer optionally formed is electrically insulating, in order in the end to produce an SeOI structure 20, the semiconductor layer of the SeOI structure then being the transferred relaxed layer 4.

Once the receiving substrate 5 has been bonded, part of the wafer 10 is removed in order to transfer the relaxed SiGe layer 4 on the receiving substrate 5 and thus produce the desired structure 20.

Substantially all that part of the wafer 10 on the matching layer 2 side in relation to the relaxed SiGe layer 4 is removed.

With reference to Figures 1e and 1f, this material removal is carried out in two steps.

A first step of material removal, shown in Figure 1e, consists in removing substantially the entire part of the wafer 10 on the matching layer 2 side in relation to the film 3.

To do this, a first material removal operation consists in detachment the donor wafer in a region of the matching layer 2 that has been weakened beforehand in this region.

Two known non-limiting techniques may thus carry out such an operation.

A first technique, called the Smart-Cut® technique, known to those skilled in the art (and descriptions of which may be found in a number of works dealing with wafer reduction techniques), consists in implanting atom species (such as hydrogen ions) and then in subjecting the implanted region, which then forms an embrittlement zone, to a heat treatment and/or mechanical treatment, or another supply of energy, in order to make the detachment in the embrittlement zone.

Detachment of the embrittlement zone thus formed in the matching layer 2 makes it possible to remove most of the wafer 10, in order to obtain a structure comprising the remainder of the matching layer 2, the strained Si film 3, the relaxed SiGe layer 4, the optional bonding layer and the receiving substrate 5.

A second technique consists in obtaining a weak interface by creating at least one porous layer, as described for example in document EP-A-0 849 788, and then in subjecting the weak layer to a mechanical treatment, or another supply of energy, in order to make the detachment in the weakened layer.

This weakened layer made of porous silicon is formed within the support substrate 1, between the support substrate 1 and the matching layer 2, in the matching layer 2 (for example between a buffer layer and a relaxed layer) or on the matching layer 2 (that is to say between the matching layer 2 and the strained Si film 3).

To form a weakened layer within the support substrate 1, the porous layer is advantageously formed on a single-crystal Si wafer and then a second growth is carried out on the porous layer, so as to grow a non-porous Si layer having substantially the same lattice parameter as the Si of the wafer; the support substrate 1 then consists of the wafer, the porous layer and the non-porous Si layer.

A detachment at the weakened layer makes it possible to remove at least some of the wafer 10, in order to obtain a structure comprising the optional remainder of the wafer 10, the strained Si film 3, the relaxed SiGe layer 4, optionally the inserted bonding layer and the receiving substrate 5.

A treatment of the wafer 10, in order to remove the porous silicon which remains after the detachment, is advantageously carried out, such as an etching operation or a heat treatment.

If the porous layer lies within the support substrate 1, a lapping, chemical-mechanical polishing and/or selective chemical etching operations are then advantageously carried out in order to remove the remaining part of the support substrate 1.

These two non-limiting techniques make it possible to rapidly remove, en bloc, a substantial part of the wafer 10.

They also allow the possibility of reusing the removed part of the wafer 10 in another process, such as for example a process according to the invention.

Thus, if the part removed is the support substrate 1, an operation to reform a matching layer 2, a film 3 and a relaxed layer 4 may be carried out as described above, after the surface of the support substrate 1 has been polished.

A second material removal operation after detaching the wafer 10 according, for example, to one of the above two techniques, consists in removing, if necessary, the remaining part of the matching layer 2.

This operation may be carried out by selective chemical etching so that the strained Si film 3 undergoes little or no etching, thus forming an etching stop layer.

The remaining part of the matching layer 2 is in this case etched by wet etching using etch solutions having substantial selectivities with respect to the strained Si film 3, such as a solution comprising HF/H₂O₂/CH₃COOH (approximately 1/1000 selectivity) or HNA (hydrofluoric-nitric-acetic solution).

Dry etching operations may also be carried out in order to remove material, such as plasma etching, or by sputtering.

This chemical method has the main advantage of being quite rapid for thin layers to be removed and of avoiding the use of chemical-mechanical polishing finishing operations usually employed after detaching the wafer.

However, the chemical etching operation may advantageously be preceded, especially in the case of a thicker layer to be removed, by mechanical or chemical-mechanical abrasion by lapping and/or chemical-mechanical polishing CMP of the remaining part of the matching layer 2.

These techniques are proposed by way of an example in the present document, but they do not in any way constitute a limitation, the invention covering all types of techniques suitable for removing material from a wafer 10 in accordance with the process according to the invention.

A first application of the invention implies a preservation of the film 3, at least partially, in order to produce a strained Si/SGOI structure.

Optionally, a growth of Si is operating on the film 3 to thicken it.

The obtained strained layer after growth should stay below the critical thickness.

As the last step of etching the remaining part of the matching layer 2 may have damaged or thinned the film 3, an advantage of thickening the film 3, is to get back the initial thickness, or a more important thickness (still below the critical thickness).

This thick strained Si layer can then be used as an active layer (taking thus advantage of electrons high mobility that a such material exhibits).

Optionally, the strained Si of the film 3, thickened or not during the previous option, is at least oxidized.

A first interest of this oxidation step is to encapsulate the underlayer of SiGe, avoiding a Ge diffusion from it.

A second interest is found if an additional annealing step is implemented in order to strengthen the bond at the bonding interface.

Other advantages may be found, as for instance, an improvement of the film 3 quality.

Indeed said bonding annealing step is generally carried out within a range of temperature that can create some defaults in the structure, as for instance pinholes. As describe in WO99/52 145, presence of a SiO₂ layer on a semiconductor layer avoids most of problems during annealing.

Using the Si of film 3 as the material to oxidize is all the more judicious than Si is industrially easier to oxidize than SiGe material.

In a particular embodiment of the invention, an enrichment step for enriching in germanium the relaxed SiGe layer 4 underneath the Si film 3 on top of the structure is carried out.

As it has already been stated before, the concentration of germanium within said relaxed SiGe layer 4 is substantially the same as that present in the relaxed Si₁₋ᵣGeᵣ layer on the surface of the SiGe lattice parameter matching layer 2.

r being limited to 30% due in particular to the limitations of the SiGe buffer layer production current techniques, the concentration of germanium within the relaxed SiGe layer 4 is thus limited.

Germanium presents an affinity with oxygen weaker than that of silicon with oxygen. Consequently, when a SiGe layer is exposed to an oxidizing atmosphere, silicon within the SiGe layer oxidizes preferentially while germanium within said SiGe layer does not react directly with oxygen.

Hence, the oxidation of a SiGe layer carried out by most of the known oxidation methods leads silicon to oxidize (forming in particular an silicon oxide layer, also called silica or SiO₂), and the germanium atoms, released by the oxidation of silicon, to migrate and accumulate at the SiO₂/SiGe interface.

Of course, as it has been underlined above, as Si is industrially easier to oxidize than SiGe, a Si layer on top of a SiGe layer (such as the Si film 3 on top of the relaxed SiGe layer 4) can help to initiate such an oxidation of a SiGe layer.

Hence a layer rich in germanium (enriched layer) is formed under the oxide layer, said enriched layer containing silicon when the oxidation is stopped before silicon is completely oxidized. A non oxidized layer of SiGe, and thus of unchanged germanium concentration, is generally under the aforementioned enriched layer, as the germanium atoms are mainly aggregated at the SiO₂/SiGe interface and not redistributed in the totality of the Si crystal.

A structure made of an oxide layer, a Si_{1-z}Ge_{z} layer and generally a Si₁₋ᵣGeᵣ layer is therefore obtained, r representing the initial germanium concentration within the SiGe layer oxidized in this manner, and z representing the germanium concentration within said enriched layer, z being higher than x.

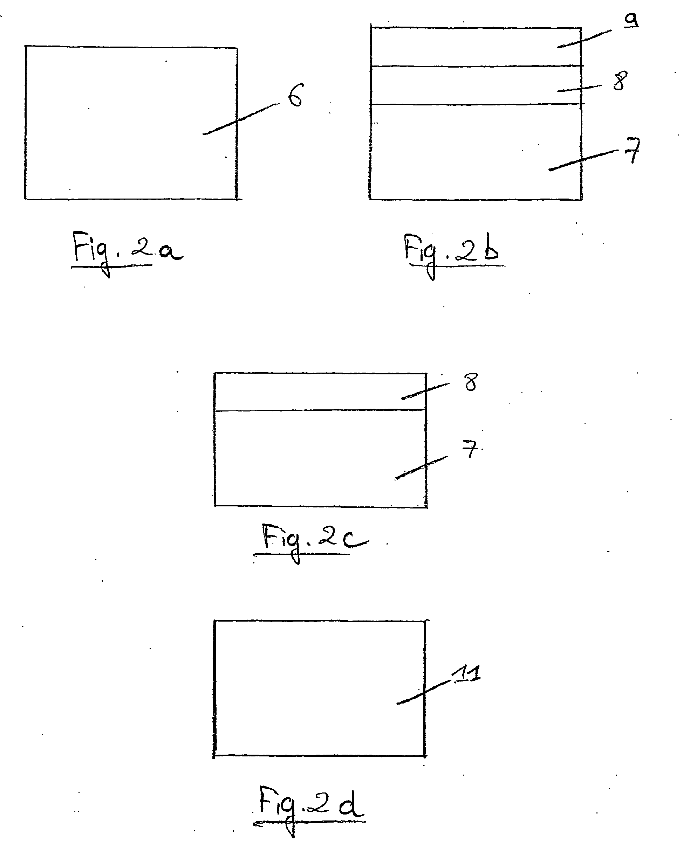

The figures 2a, 2b, 2c and 2d illustrate such a step of enrichment in germanium of a Si₁₋ᵣGeᵣ layer 6.

The enrichment step of such a layer 6 thus comprises an oxidation operation of the aforementioned Si_{1- r}Geᵣ layer 6, possibly followed by a deoxidation operation for removing the oxide layer formed during the oxidation operation.

A heat treatment operation can also be carried out for homogenizing the concentration of germanium within the enriched layer.

The oxidation operation is a classical oxidation known to those skilled in the art. The oxidation operation is preferentially carried out at a temperature ranging between 700°C and 1100°C. It can be carried out by dry or wet process. Using dry process, oxidation is for instance carried out by heating the substrate under gas oxygen. Using wet process, oxidation is carried out by heating the substrate in an atmosphere charged with steam.

Following this oxidation operation, and as it is represented on figure 2b, a surface oxide layer 9 is formed and a Si_{1-z}Ge_{z} layer 8 enriched in germanium (z being higher than r) is underneath the oxide layer 9. Said oxide layer 9 comprises mainly silica SiO2, but, according to various parameters such as for example:
- the oxidation operation conditions,
- the initial concentration r of germanium within the Si₁₋ᵣGeᵣ layer 6, or
- the initial thickness of the Si₁₋ᵣGeᵣ layer 6 thus oxidized,
a composite SiGe oxide (Si_{y}GeₜO₂) oxide can be also formed.

Thus, for instance, only a low temperature wet oxidation operation leads to the formation of such a SiGe oxide (Si_{y}GeₜO₂).

As it has been stated previously, if the oxidation operation takes only effect in a near surface area of the Si₁₋ᵣGeᵣ layer 6, a non oxidized Si₁₋ᵣGeᵣ layer 7, and thus of unchanged germanium concentration, is under the aforementioned enriched Si_{1-z}Ge_{z} layer 8.

The deoxidation operation aims at removing the oxide layer 9 formed during the oxidation operation. The deoxidation operation is preferentially carried out in a traditional way. For this purpose, the substrate can be plunged during a few minutes in a solution of hydrofluoric acid to 10% or 20% for example.

As it is represented on figure 2c, a structure made up of the aforementioned enriched Si_{1-z}Ge_{z} layer 8 and, possibly, of said Si₁₋ᵣGeᵣ layer 7 of unchanged germanium concentration can be obtained next to said deoxidation operation.

Advantageously, the enrichment step comprises a heat treatment operation to allow the redistribution of the germanium atoms in the crystal of Si. Hence, the heat treatment step is adapted for obtaining a SiGe layer enriched in germanium and of homogeneous concentration in germanium.

Said heat treatment operation is preferably carried out at a temperature of approximately 1200°C.

Said heat treatment operation is carried out after the oxidation step and preferably prior to the deoxidation step.

However, said heat treatment operation can also be carried out after both oxidation and deoxidation steps.

In one embodiment of the invention, said enrichment step does not comprise a deoxydation operation. Thus the enriched SiGe layer is encapsulated by an oxide layer, avoiding, as mentioned above, a Ge diffusion from it.

Figures 2a to 2d illustrate an enrichment step comprising, in the order, an oxidation operation, a deoxydation operation and a heat treatment operation. An enriched Si₁₋ₖGeₖ layer 11 (figure 2d) of homogeneous concentration k in germanium is thus formed, k being comprised between the initial concentration r of the initial Si₁₋ᵣGeᵣ layer 6 and the concentration of said enriched Si_{1-z}Ge_{z} layer 8.

Finally a light polishing, preferably a chemical-mechanical polishing (CMP), can be carried out in order to decrease the surface roughness and to improve the thickness uniformity of the enriched Si₁₋ₖGeₖ layer 11.

Of course several enrichment steps can be successively carried out in order to control as well as possible, and to increase significantly, the germanium concentration within the SiGe layer thus treated

Thus, thanks to such an enrichment step, the concentration of germanium within the SiGe layer 4 (underneath the preserved Si film 3 before said enrichment step; see figure 1e) can be increased, and more particularly can exceed the typical 30% limitation.

Such an increased germanium concentration can indeed reach 80% and is generally approximately 50%.

A second application of the invention implies, prior to any enrichment step, a removal of the film 3 by a chemical way, as shown in Figure 1f.

To do this, it is preferred to use selective etching employing an etch solution exhibiting high selectivity with respect to the relaxed SiGe layer 4, such as a solution comprising at least one of the following compounds: KOH (potassium hydroxide), NH₄OH (ammonium hydroxide), TMAH (tetramethylammonium hydroxide), EDP (ethylenediamine / pyrocatechol / pyrazine) or HNO₃, or solutions currently under study combining agents such as HNO₃, HNO₂H₂O₂, HF, H₂SO₄, H₂SO₂, CH₃COOH, H₂O₂ and H₂O, as explained in document WO 99/53539, page 9.

This second step makes it possible to retain good surface quality and good thickness homogeneity of the relaxed SiGe layer 4.

Thus, a layer quality substantially identical to that obtained during its growth (shown in Figure 1 c) is retained.

This is because this transferred layer 4 has not necessarily been subjected to external mechanical stresses, such as those generated by a CMP finishing step, thus avoiding the appearance of defects associated with such stresses.

However, in certain particular cases, soft polishing is carried out in order to remove any slight surface roughness.

Thus, a final relaxed SiGe-on-substrate structure is obtained, and in particular a relaxed SiGe-on-insulator structure (also called an SGOI structure) if the subjacent material of the relaxed SiGe layer 4 is an electrical insulator.

In a particular embodiment of said second application of the invention, an enrichment step can be carried out on said final relaxed SiGe-on-substrate structure.

As it has been presented previously, such an enrichment step allows to increase the germanium content within the relaxed SiGe layer 4 on top of said SiGe-on-substrate structure.

In another particular embodiment, any epitaxy may be carried out on the relaxed SiGe layer, such as epitaxy of another SiGe layer or epitaxy of a strained Si layer.

In the latter case, an Si/SGOI final structure is obtained, the Si layer being strained.

It has to be noticed that, when the structure has been subjected to one or more enrichment steps, the germanium concentration within the final relaxed SiGe layer is increased and can exceed the typical 30% limitation.

Hence, the enrichment step helps to control the germanium concentration within the final relaxed SiGe layer, and thus the lattice parameter of such a layer. Finally, the strain exerted on a film epitaxially grown on said relaxed SiGe layer can also be controlled.

In particular, a Si/SGOI final structure can be obtained, the Si film being particularly strained.

Having completed the final structure, a finishing step may optionally be carried out, such as finishing treatments like, for example, a heat treatment in order to further strengthen the bonding interface with the receiving substrate 5.

The present invention is not limited to an SiGe lattice parameter matching layer 2, but also extends to a constitution of the matching layer 2 from other types of type III-V materials or other materials capable of straining the material of the epitaxially overgrown film 3.

The present invention is not limited to a film 3 of strained Si, but also extends to a constitution of it from other types of III-V materials or other materials capable to be strained by the underlying matching layer 2.

In the semiconductor layers, other constituents may be added thereto, such as carbon with a carbon concentration in the layer in question substantially less than or equal to 50% or more particularly with a concentration of less than or equal to 5%.

In addition, and in a similar way to what was described previously for the enrichment in germanium of a SiGe layer, as silicon Si also oxidizes selectively to carbon C, layers of semiconductor materials such as SiGeC alloys or Si1-yCy alloys, y being weak, can be enriched in their component carbon by oxidation.

Finally, the present invention does not relate only to transferring a relaxed SiGe layer 4, but in general relates to transferring a layer of any type of semiconductor able to be transferred according to a process of the invention.

## Claims

1. Method of producing a structure comprising a thin layer of semiconductor material obtained from a wafer (10), the wafer (10) comprising a lattice parameter matching layer (2) comprising an upper layer of a material chosen from semiconductor materials having a first lattice parameter, the method comprising the following steps :
(a) growth on the upper layer of the matching layer (2) of a film (3) of a material chosen from semiconductor materials, said grown film (3) being of a material having a nominal lattice parameter substantially different from the first lattice parameter, said grown film (3) having a thickness small enough to keep the first lattice parameter of the upper layer of the underlyed matching layer (2) and thus to be strained;
(b) growth on the film (3) of a relaxed layer (4), said relaxed layer (4) being of a material chosen from semiconductor materials comprising silicon and at least another element and having a nominal lattice parameter substantially identical to the first lattice parameter;
(c) removal of a part of the wafer (10), **characterized by** the following operations:
- formation of an embrittlement zone in the matching layer (2) ; and
- supply of energy in order to detach, at the embrittlement zone level, the part of the wafer (10) comprising the relaxed layer (4), thus forming the structure to produce;
(d) enrichment in an element other than silicon of the relaxed layer (4) comprised in the detached part of the wafer (10).

2. Method of producing a structure according to the preceding claim, **characterized in that** the enrichment step (d) comprises an oxidation operation of the detached part of the wafer (10) for forming an oxide layer on the surface of the thus oxidized detached part of the wafer (10) and increasing the concentration of the element other than silicon in a region of said relaxed layer (4) which is subjacent said oxide layer.

3. Method of producing a structure according to the preceding claim, **characterized in that** the enrichment step (d) further comprises a heat treatment operation for homogenising the concentration of the element other than silicon within said oxidized part of the wafer (10).

4. Method of producing a structure according to claim 2, **characterized in that** the enrichment step (d) further comprises a deoxidation operation for removing the oxide layer formed during said oxidation operation.

5. Method of producing a structure according to claim 4, **characterized in that** the enrichment step (d) further comprises a heat treatment operation for homogenising the concentration of the element other than silicon within said oxidized part of the wafer (10), said heat treatment operation being carried out either before or after said deoxydation operation.

6. Method of producing a structure according to the preceding claim, **characterized in that** the heat treatment operation is carried out at a temperature of approximately 1200°C.

7. Method of producing a structure according to any one of the preceding claims, **characterized in that,** after step (b), an additional step is carried out in which a receiving substrate (5) is bonded to the wafer (10) on the relaxed layer (4) side.

8. Method of producing a structure according to the preceding claim, **characterized in that** the receiving substrate (5) is made of silicon.

9. Method of producing a structure according to any one of the two preceding claims, **characterized in that,** before bonding, a step of forming at least one bonding layer between the receiving substrate and the wafer (10) is furthermore carried out, the bonding layer being formed on the receiving substrate (5) and/or on the bonding face of the wafer (10).

10. Method of producing a structure according to the preceding claim, **characterized in that** the bonding layer is an electrically insulating material.

11. Method of producing a structure according to the preceding claim, **characterized in that** the bonding layer is made of silica.

12. Method of producing a structure according to the preceding claim, **characterized in that** the bonding layer is formed by thermal oxidation.

13. Method of producing a structure according to one of the preceding claims, **characterized in that** the embrittlement zone is formed by implantation of species into the matching layer (2) at a depth substantially equal to the implant depth.

14. Method of producing a structure according to one of claims 1 to 11, **characterized in that,** before step (b), the embrittlement zone is formed by porosification of a layer beneath the relaxed layer (4).

15. Method of producing a structure according to one of the preceding claims, **characterized in that** the removal step (c) comprises, after the energy supply operation of step (c), at least one selective etching operation.

16. Method of producing a structure according to the preceding claim, **characterized in that** a selective etching operation relates to the etching of the remaining part of the matching layer (2) with respect to the film (3) (after detachment of the wafer (10) by energy supply).

17. Method of producing a structure according to the preceding claim, **characterized in that** it further comprises after said etching operation and before the enrichment step (d) a growth of a film of a material chosen from semiconductor materials on the film (3), said semiconductor material being substantially the same as the one of the film (3).

18. Method of producing a structure according to any of the two preceding claims, **characterized in that** it further comprises an oxidation of the film (3).

19. Method of producing a structure according to the preceding claim, **characterized in that** an annealing treatment is operated at the same time or following the oxidation, this annealing treatment being able to strengthen the bonding interface.

20. Method of producing a structure according to the claims 14 or 15, **characterized in that** a selective etching operation relates to the etching of the film (3) with respect to the relaxed layer (4).

21. Method of producing a structure according to one of the preceding claims, **characterized in that** it furthermore comprises, after step (d), a step of growing a layer on the relaxed layer (4).

22. Method of producing a structure according to the receding claim, **characterized in that** the growth layer on the relaxed layer (4) is made of strained material.

23. Method of producing a structure according to any one of the preceding claims, **characterized in that:**
- the matching layer (2) is made of silicon-germanium, the matching layer (2) comprising a buffer layer with a germanium concentration which increases through the thickness and a relaxed layer beneath the film (3);
- the film (3) of strained material is made of silicon;
- the element other than silicon is germanium Ge so that the relaxed layer (4) is made of substantially relaxed silicon-germanium, with a germanium concentration substantially equal to the germanium concentration of the relaxed layer of the matching layer (2).

24. Method of producing a structure according to any one of the claims 1 to 21, **characterized in that** the element other than silicon in the relaxed layer (4) is carbon C.

25. Method of producing a structure according to any one of the claims 1 to 21, **characterized in that** the element other than silicon in the relaxed layer (4) is an alloy germanium-carbon.

26. Method of producing a structure according to claim 22 and one of the claims 23 to 25, **characterized in that** the growth layer produced on the relaxed layer (4) is made of strained silicon so as to substantially preserve the lattice parameter of the subjacent relaxed layer (4).

27. Method of producing a structure according to one of the preceding claims, **characterized in that** the wafer (10) comprises at least one layer furthermore containing carbon with a carbon concentration in the layer substantially less than or equal to 50%.

28. Method of producing a structure according to one of the preceding claims, **characterized in that** the wafer (10) comprises at least one layer furthermore containing carbon with a carbon concentration in the layer substantially less than or equal to 5%.

29. Structure obtained after the enrichment step (d) of the method according to claim 7 and any one of claims 8 to 29, comprising in succession at least the receiving substrate (5) and the relaxed layer (4) comprised in the detached part of the wafer (10) and enriched in its element other than silicon, **characterized in that** said relaxed layer (4) has a lattice parameter substantially superior to said first lattice parameter.

30. Application of the method according to claims 1 to 29, to the production of one of the following "semiconductor on insulator" structures : SGOI ; strained Si / SGOI, SiGe / strained Si / SGOI ; SiO₂ / SGOI.

## Patentansprüche

1. Verfahren zum Herstellen einer Struktur, umfassend eine Dünnschicht aus einem Halbleitermaterial aus einem Wafer (10), wobei der Wafer (10) eine Gitterparameter-Abgleichslage (2) umfasst, umfassend eine obere Lage aus einem Material, das ausgewählt ist aus Halbleitermaterial mit einem ersten Gitterparameter, wobei das Verfahren die folgenden Schritte umfasst:
(a) Wachstum an der oberen Lage der Abgleichslage (2) einer Folie (3) aus einem Material, das ausgewählt ist aus Halbleitermaterial, wobei die genannte Wachstumsfolie (3) aus einem Material mit einem nominalen Gitter besteht, das sich im Wesentlichen vom ersten Gitterparameter unterscheidet, wobei die genannte Wachstumsfolie (3) eine Dicke aufweist, die gering genug ist, um den ersten Gitterparameter der oberen Lage der darunter liegenden Abgleichslage (2) beizubehalten und **dadurch** verspannt zu werden;
(b) Wachstum der Folie (3) auf einer entspannten Lage (4), wobei die genannte entspannte Lage (4) aus einem Material besteht, das ausgewählt ist aus Halbleitermaterial, umfassend Silikon, und wenigstens einem weiteren Element, und mit einem nominalen Gitterparameter, der im Wesentlichen mit dem ersten Gitterparameter identisch ist;
(c) Entfernen eines Teils des Wafers (10), **gekennzeichnet durch** die nachfolgenden Vorgänge:
- Bildung einer Versprödungszone in der Abgleichslage (2) und
- Zufuhr an Energie, um den Teil des Wafers (10) umfassend die entspannte Lage (4) auf derVersprödungszonenebene loszulösen und **dadurch** die herzustellende Struktur zu bilden;
(d) Anreichern der im losgelösten Teil des Wafers (10) vorhandenen entspannten Lage (4) in einem Element, das nicht Silikon ist.

2. Verfahren zur Herstellung einer Struktur nach vorstehendem Anspruch, **dadurch gekennzeichnet, dass** der Anreicherungsschritt (d) einen Oxidierungsschritt des losgelösten Teils des Wafers (10) zum Bilden einer Oxidlage auf der Fläche des auf diese Weise oxidierten, losgelösten Teils des Wafers (10) umfasst und Erhöhen der Konzentration des Elements, das nicht Silikon ist, in einem Bereich der genannten entspannten Lage (4), die unter der genannten Oxidlage liegt.

3. Verfahren zur Herstellung einer Struktur nach vorstehendem Anspruch, **dadurch gekennzeichnet, dass** der Anreicherungsschritt (d) ferner einen Hitzebehandlungsvorgang zur Homogenisierung der Konzentration des Elements, das nicht Silikon ist, innerhalb des genannten oxidierten Teils des Wafers (10) umfasst.

4. Verfahren zur Herstellung einer Struktur nach Anspruch 2, **dadurch gekennzeichnet, dass** der Anreicherungsschritt (d) ferner einen Desoxidationsvorgang zum Entfernen der Oxidlage während dem genannten Oxidierungsvorgang umfasst.

5. Verfahren zur Herstellung einer Struktur nach Anspruch 4, **dadurch gekennzeichnet, dass** der Anreicherungsschritt (d) ferner einen Hitzebehandlungsvorgang zur Homogenisierung der Konzentration des Elements, das nicht Silikon ist, innerhalb des genannten oxidierten Teils des Wafers (10) umfasst, der entweder vor oder nach dem genannten Desoxidationsvorgang durchgeführt wird.

6. Verfahren zur Herstellung einer Struktur nach vorstehendem Anspruch, **dadurch gekennzeichnet, dass** der Hitzebehandlungsvorgang bei einer Temperatur von ungefähr 1200 °C durchgeführt wird.

7. Verfahren zur Herstellung einer Struktur nach einem der vorstehenden Ansprüche, **dadurch gekennzeichnet, dass** nach Schritt (b) ein weiterer Schritt durchgeführt wird, bei dem ein Aufnahmesubstrat (5) mit dem Wafer (10) auf der Seite der entspannten Lage (4) verbunden wird.

8. Verfahren zur Herstellung einer Struktur nach vorstehendem Anspruch, **dadurch gekennzeichnet, dass** das Aufnahmesubstrat (5) aus Silikon besteht.

9. Verfahren zur Herstellung einer Struktur nach einem der vorstehenden Ansprüche, **dadurch gekennzeichnet, dass** weiterhin vor dem Verbinden ein Schritt zum Bilden wenigstens einer Verbindungslage zwischen dem Aufnahmesubstrat und dem Wafer (10) durchgeführt wird, wobei die Verbindungslage auf dem Aufnahmesubstrat (5) und/oder auf der Verbindungsfläche des Wafers (10) gebildet ist.

10. Verfahren zur Herstellung einer Struktur nach vorstehendenn Anspruch, **dadurch gekennzeichnet, dass** die Verbindungslage aus einem elektrisch leitenden Material besteht.

11. Verfahren zur Herstellung einer Struktur nach vorstehendenn Anspruch, **dadurch gekennzeichnet, dass** die Verbindungslage aus Silikon besteht.

12. Verfahren zur Herstellung einer Struktur nach vorstehendenn Anspruch, **dadurch gekennzeichnet, dass** die Verbindungslage durch Thermaloxidierung gebildet ist.

13. Verfahren zur Herstellung einer Struktur nach einem der vorstehenden Ansprüche, **dadurch gekennzeichnet, dass** die Versprödungszone durch Implantation von Spezies in die Abgleichslage (2) bei einer Tiefe von im Wesentlichen entsprechend der Implantattiefe gebildet ist.

14. Verfahren zur Herstellung einer Struktur nach einem der Ansprüche 1 bis 11, **dadurch gekennzeichnet, dass** vor Schritt (b) die Versprödungszone durch Porösifizierung einer Lage unterhalb der entspannten Lage (4) gebildet ist.

15. Verfahren zur Herstellung einer Struktur nach einem der vorstehenden Ansprüche, **dadurch gekennzeichnet, dass** der Entfernungsschritt (c) nach dem Energiezufuhrvorgang von Schritt (c) wenigstens einen selektiven Ätzvorgang umfasst.

16. Verfahren zur Herstellung einer Struktur nach vorstehendem Anspruch, **dadurch gekennzeichnet, dass** sich ein selektiver Ätzvorgang auf das Ätzen des restlichen Teils der Abgleichslage (2) in Bezug auf die Folie (3) (nach Loslösen des Wafers (10) durch Energiezufuhr) bezieht.

17. Verfahren zur Herstellung einer Struktur nach vorstehendem Anspruch, **dadurch gekennzeichnet, dass** dieses ferner nach dem genannten Ätzvorgang und vor dem Anreicherungsschritt (d) ein Wachstum einer Folie aus einem Material, ausgewählt aus Halbleitermaterial, auf der Folie (3) umfasst, wobei das genannte Halbleitermaterial im Wesentlichen das gleiche ist, wie das auf der Folie (3) vorhandene.

18. Verfahren zur Herstellung einer Struktur nach einem der beiden vorstehenden Ansprüche, **dadurch gekennzeichnet, dass** dieses ferner eine Oxidierung auf der Folie (3) umfasst.

19. Verfahren zur Herstellung einer Struktur nach vorstehendem Anspruch, **dadurch gekennzeichnet, dass** gleichzeitig oder nach der Oxidierung eine Glühbehandlung durchgeführt wird, wobei diese Glühbehandlung in der Lage ist, die Verbindungsstellen zu verstärken.

20. Verfahren zur Herstellung einer Struktur nach einem der Ansprüche 14 oder 15, **dadurch gekennzeichnet, dass** sich ein selektiver Ätzvorgang auf das Ätzen der Folie (3) in Bezug auf die entspannte Lage (4) bezieht.

21. Verfahren zur Herstellung einer Struktur nach einem der vorstehenden Ansprüche, **dadurch gekennzeichnet, dass** dieses ferner nach Schritt (d) einen Schritt für das Wachstum einer Lage auf der entspannten Lage (4) umfasst.

22. Verfahren zur Herstellung einer Struktur nach vorstehendem Anspruch, **dadurch gekennzeichnet, dass** die Wachstumslage auf der entspannten Lage (4) aus einem verspannten Material besteht.

23. Verfahren zur Herstellung einer Struktur nach einem der vorstehenden Ansprüche, **dadurch gekennzeichnet, dass:**
- die Abgleichslage (2) aus Silikon-Germanium besteht, wobei die Abgleichslage (2) eine Pufferlage mit einer Germaniumkonzentration umfasst, die sich durch die Dicke hindurch erhöht, sowie eine entspannte Lager unterhalb der Folie (3);
- die aus verspanntem Material bestehende Folie (3) aus Silikon besteht;
- das Element, das nicht Silikon ist, Germanium Ge ist, sodass die entspannte Lage (4) im Wesentlichen aus entspanntem Silikon-Germanium besteht, mit einer Germaniumkonzentration, die im Wesentlichen der Germaniumkonzentration der entspannten Lage der Abgleichslage (2) gleich ist.

24. Verfahren zur Herstellung einer Struktur nach einem der Ansprüche 1 bis 21, **dadurch gekennzeichnet, dass** das Element, das nicht Silikon ist, in der entspannten Lage (4) Kohlenstoff C ist.

25. Verfahren zur Herstellung einer Struktur nach einem der Ansprüche 1 bis 21, **dadurch gekennzeichnet, dass** das Element, das nicht Silikon ist, in der entspannten Lage (4) eine Germanium-/Kohlenstofflegierung ist.

26. Verfahren zur Herstellung einer Struktur nach Anspruch 22 und nach einem der Ansprüche 23 bis 25, **dadurch gekennzeichnet, dass** die auf der entspannten Lage (4) hergestellte Wachstumslage aus verspanntem Silikon besteht, um den Gitterparameter der darunter liegenden entspannten Lage (4) im Wesentlichen zu konservieren.

27. Verfahren zur Herstellung einer Struktur nach einem der vorstehenden Ansprüche, **dadurch gekennzeichnet, dass** der Wafer (10) wenigstens eine Lage umfasst, die ferner Kohlenstoff bei einer Kohlenstoffkonzentration in der Lage von im Wesentlichen weniger als oder gleich 50% enthält.

28. Verfahren zur Herstellung einer Struktur nach einem der vorstehenden Ansprüche, **dadurch gekennzeichnet, dass** der Wafer (10) wenigstens eine Lage umfasst, die ferner Kohlenstoff bei einer Kohlenstoffkonzentration in der Lage von im Wesentlichen weniger als oder gleich 5% enthält.

29. Struktur, die nach dem Anreicherungsschritt (d) des Verfahrens nach Anspruch 7 und einem der Ansprüche 8 bis 29 erhalten wird, umfassend nacheinander wenigstens das Aufnahmesubstrat (5) und die im losgelösten Teil des Wafers (10) enthaltene entspannte Lage (4) und das mit anderen Elementen als Silikon angereichert ist, **dadurch gekennzeichnet, dass** die genannte entspannte Lage (4) einen Gitterparameter aufweist, der im Wesentlichen dem genannten ersten Gitterparameter übergeordnet ist.

30. Anwendung des Verfahrens nach Ansprüchen 1 bis 29 auf die Herstellung einer der nachfolgenden "Halbleiter auf Isolatorteil"-Strukturen: SGOI ; verspanntes SI / SGOI, SiGe / verspanntes SI / SGOI ; SiO₂ / SGOI.

## Revendications

1. Procédé de production d'une structure comprenant une fine couche de matériau semi-conducteur obtenue à partir d'une tranche (10), la tranche (10) comprenant une couche de concordance de paramètre de réseau cristallin (2) comprenant une couche supérieure d'un matériau choisi parmi les matériaux semi-conducteurs ayant un premier paramètre de réseau cristallin, le procédé comprenant les étapes suivantes :
(a) croissance sur la couche supérieure de la couche de concordance (2) d'un film (3) d'un matériau choisi parmi des matériaux semi-conducteurs, ledit film ayant crû (3) étant constitué d'un matériau ayant un paramètre de réseau cristallin nominal sensiblement différent du premier paramètre de réseau cristallin, ledit film ayant crû (3) ayant une épaisseur suffisamment petite pour maintenir le premier paramètre de réseau cristallin de la couche supérieure de la couche de concordance sous-jacente (2) et pour être ainsi contraint ;
(b) croissance sur le film (3) d'une couche relaxée (4), ladite couche relaxée (4) étant constituée d'un matériau choisi parmi des matériaux semi-conducteurs comprenant le silicium et au moins un autre élément et ayant un paramètre de réseau cristallin nominal sensiblement identique au premier paramètre de réseau cristallin ;
(c) élimination d'une partie de la tranche (10), **caractérisé par** les opérations suivantes :
- formation d'une zone de fragilisation dans la couche de concordance (2) ; et
- fourniture d'énergie afin de détacher, au niveau de la zone de fragilisation, la partie de la tranche (10) comprenant la couche relaxée (4), formant ainsi la structure à produire ;
(d) enrichissement en un élément autre que le silicium de la couche relaxée (4) comprise dans la partie détachée de la tranche (10).

2. Procédé de production d'une structure selon la revendication précédente, **caractérisé en ce que** l'étape d'enrichissement (d) comprend une opération d'oxydation de la partie détachée de la tranche (10) pour former une couche d'oxyde sur la surface de la partie détachée ainsi oxydée de la tranche (10) et augmenter la concentration de l'élément autre que le silicium dans une région de ladite couche relaxée (4) qui est sous-jacente à ladite couche d'oxyde.

3. Procédé de production d'une structure selon la revendication précédente, **caractérisé en ce que** l'étape d'enrichissement (d) comprend en outre une opération de traitement à la chaleur pour homogénéiser la concentration de l'élément autre que le silicium dans ladite partie oxydée de la tranche (10).

4. Procédé de production d'une structure selon la revendication 2, **caractérisé en ce que** l'étape d'enrichissement (d) comprend en outre une opération de désoxydation pour éliminer la couche d'oxyde formée pendant ladite opération d'oxydation.

5. Procédé de production d'une structure selon la revendication 4, **caractérisé en ce que** l'étape d'enrichissement (d) comprend en outre une opération de traitement à la chaleur pour homogénéiser la concentration de l'élément autre que le silicium dans ladite partie oxydée de la tranche (10), ladite opération de traitement à la chaleur étant réalisée soit avant, soit après ladite opération de désoxydation.

6. Procédé de production d'une structure selon la revendication précédente, **caractérisé en ce que** l'opération de traitement à la chaleur est réalisée à une température d'approximativement 1 200 °C.

7. Procédé de production d'une structure selon l'une quelconque des revendications précédentes,
**caractérisé en ce que,** après l'étape (b), une étape supplémentaire est réalisée dans laquelle un substrat récepteur (5) est lié à la tranche (10) du côté de la couche relaxée (4).

8. Procédé de production d'une structure selon la revendication précédente, **caractérisé en ce que** le substrat récepteur (5) est constitué de silicium.

9. Procédé de production d'une structure selon l'une quelconque des deux revendications précédentes,
**caractérisé en ce que,** avant liaison, une étape de formation d'au moins une couche de liaison entre le substrat récepteur et la tranche (10) est en outre réalisée, la couche de liaison étant formée sur le substrat récepteur (5) et/ou sur la face de liaison de la tranche (10).

10. Procédé de production d'une structure selon la revendication précédente, **caractérisé en ce que** la couche de liaison est un matériau électriquement isolant.

11. Procédé de production d'une structure selon la revendication précédente, **caractérisé en ce que** la couche de liaison est constituée de silice.

12. Procédé de production d'une structure selon la revendication précédente, **caractérisé en ce que** la couche de liaison est formée par oxydation thermique.

13. Procédé de production d'une structure selon l'une des revendications précédentes, **caractérisé en ce que** la zone de fragilisation est formée par implantation d'espèces dans la couche de concordance (2) à une profondeur sensiblement égale à la profondeur d'implantation.

14. Procédé de production d'une structure selon l'une des revendications 1 à 11, **caractérisé en ce que,** avant l'étape (b), la zone de fragilisation est formée par porosification d'une couche en dessous de la couche relaxée (4).

15. Procédé de production d'une structure selon l'une des revendications précédentes, **caractérisé en ce que** l'étape d'élimination (c) comprend, après l'opération de fourniture d'énergie de l'étape (c), au moins une opération de gravage sélectif.

16. Procédé de production d'une structure selon la revendication précédente, **caractérisé en ce qu'**une opération de gravage sélectif concerne le gravage de la partie restante de la couche de concordance (2) par rapport au film (3) (après détachement de la tranche (10) par fourniture d'énergie).

17. Procédé de production d'une structure selon la revendication précédente, **caractérisé en ce qu'**il comprend en outre après ladite opération de gravage et avant l'étape d'enrichissement (d), une croissance d'un film d'un matériau choisi parmi les matériaux semi-conducteurs sur le film (3), ledit matériau semi-conducteur étant sensiblement le même que celui du film (3).

18. Procédé de production d'une structure selon l'une des deux revendications précédentes, **caractérisé en ce qu'**il comprend en outre une oxydation du film (3).

19. Procédé de production d'une structure selon la revendication précédente, **caractérisé en ce qu'**un traitement de recuit est effectué en même temps que l'oxydation ou après cette dernière, ce traitement de recuit permettant de renforcer l'interface de liaison.

20. Procédé de production d'une structure selon les revendications 14 ou 15, **caractérisé en ce qu'**une opération de gravage sélectif concerne le gravage du film (3) par rapport à la couche relaxée (4).

21. Procédé de production d'une structure selon l'une des revendications précédentes, **caractérisé en ce qu'**il comprend en outre, après l'étape (d), une étape de croissance d'une couche sur la couche relaxée (4).

22. Procédé de production d'une structure selon la revendication précédente, **caractérisé en ce que** la couche de croissance sur la couche relaxée (4) est constituée d'un matériau contraint.

23. Procédé de production d'une structure selon l'une quelconque des revendications précédentes, **caractérisé en ce que :**
- la couche de concordance (2) est constituée de silicium-germanium, la couche de concordance (2) comprenant une couche tampon avec une concentration en germanium qui augmente à travers l'épaisseur et une couche relaxée en dessous du film (3) ;
- le film (3) en matériau contraint est constitué de silicium ;
- l'élément autre que le silicium est le germanium Ge si bien que la couche relaxée (4) est constituée de silicium-germanium sensiblement relaxé, avec une concentration en germanium sensiblement égale à la concentration en germanium de la couche relaxée de la couche de concordance (2).

24. Procédé de production d'une structure selon l'une quelconque des revendications 1 à 21, **caractérisé en ce que** l'élément autre que le silicium dans la couche relaxée (4) est le carbone C.

25. Procédé de production d'une structure selon l'une quelconque des revendications 1 à 21, **caractérisé en ce que** l'élément autre que le silicium dans la couche relaxée (4) est un alliage germanium-carbone.

26. Procédé de production d'une structure selon la revendication 22 et l'une des revendications 23 à 25, **caractérisé en ce que** la couche de croissance produite sur la couche relaxée (4) est constituée de silicium contraint de façon à préserver sensiblement le paramètre de réseau cristallin de la couche relaxée sous-jacente (4).

27. Procédé de production d'une structure selon l'une des revendications précédentes, **caractérisé en ce que** la tranche (10) comprend au moins une couche contenant en outre du carbone avec une concentration en carbone dans la couche sensiblement inférieure ou égale à 50 %.

28. Procédé de production d'une structure selon l'une des revendications précédentes, **caractérisé en ce que** la tranche (10) comprend au moins une couche contenant en outre du carbone avec une concentration en carbone dans la couche sensiblement inférieure ou égale à 5 %.

29. Structure obtenue après l'étape d'enrichissement (d) du procédé selon la revendication 7 et l'une quelconque des revendications 8 à 29, comprenant en succession au moins le substrat récepteur (5) et la couche relaxée (4) comprise dans la partie détachée de la tranche (10) et enrichie en son élément autre que le silicium, **caractérisée en ce que** ladite couche relaxée (4) a un paramètre de réseau cristallin sensiblement supérieur audit premier paramètre de réseau cristallin.

30. Application du procédé selon les revendications 1 à 29, à la production de l'une des structures « semi-conducteur sur isolant » suivantes : SGOI ; SI contraint/SGOI, SiGe/Si contraint/SGOI ; SiO₂/SGOI.
